(19) Europäisches Patentamt

European Patent Office

Office européen des brevets

(11) Veröffentlichungsnummer: **0 264 679 B1**

(12) **EUROPÄISCHE PATENTSCHRIFT**

(45) Veröffentlichungstag der Patentschrift: **18.03.92**

(21) Anmeldenummer: **87114331.9**

(22) Anmeldetag: **01.10.87**

(51) Int. Cl.⁵: **H01L 21/304**, B24B 9/06

(54) **Verfahren zum Anbringen einer abgeschrägten Randkontur an einer Halbleiterscheibe.**

(30) Priorität: **13.10.86 CH 4070/86**

(43) Veröffentlichungstag der Anmeldung:
**27.04.88 Patentblatt 88/17**

(45) Bekanntmachung des Hinweises auf die
Patenterteilung:
**18.03.92 Patentblatt 92/12**

(84) Benannte Vertragsstaaten:
**CH DE FR GB IT LI SE**

(56) Entgegenhaltungen:
**DE-A- 3 026 272**
**FR-A- 2 437 271**
**US-A- 4 227 347**

**PATENT ABSTRACTS OF JAPAN, Band 8, Nr.
47 (M-288) [1484], 2. März 1984, Seite 159 M
280; & JP-A-58 202 758**

**IDEM**

**PATENT ABSTRACTS OF JAPAN, Band 9, Nr.
100 (M-376) [1823], 2. Mai 1985, Seite 29 M
376; & JP-A-59 224 250**

**PATENT ABSTRACTS OF JAPAN, Band 6, Nr.
91 (E-109)[969], 28. Mai 1982, Seite 142 E 109;**

**& JP-A-57 26 439**

(73) Patentinhaber: **BBC Brown Boveri AG
Haselstrasse
CH-5401 Baden(CH)**

(72) Erfinder: **Dlouhy, Jiri
Haldenstrasse 410
CH-5506 Mägenwil(CH)**

## Beschreibung

### Technisches Gebiet

Die Erfindung bezieht sich auf ein Verfahren zum Anbringen einer abgeschrägten Randkontur an einer Halbleiterscheibe, insbesondere für Mittel- und Hochspannungsdioden.

### Stand der Technik

Es ist seit langem bekannt, bei hochsperrenden Leistungshalbleiter-Bauelementen, insbesondere bei Mittel- und Hochspannungsdioden mit Legierkontakt, die dem Bauelement zugrundeliegende Halbleiterscheibe mit einer in geeigneter Weise abgeschrägten Randkontur (sog. "positiver Winkel") zu versehen, um die elektrische Feldstärke an der Oberfläche herabzusetzen und näherungsweise eine Spannungsfestigkeit zu erreichen, wie sie durch die Volumeneigenschaften vorgegeben ist.

Eine solche abgeschrägte Randkontur ist im Stand der Technik auf verschiedene Weise hergestellt worden. So ist z.B. in der DE-PS 15 89 421 vorgeschlagen worden, die Randkontur mittels eines Ultraschallwerkzeuges, beispielsweise eines Ultraschallbohrers, an der Halbleiterscheibe anzubringen.

Aus JP-A 58 202 758 ist eine Schleifmaschine zur Bearbeitung des Randes eines Silizium Wafers bekannt. Eine tassenförmige Schleifscheibe bearbeitet den Wafer mit ihrer Hauptfläche, d.h. mit einer zur Rotationsachse senkrechten Fläche. Die Rotationsachse wird so geneigt, dass am Wafer der gewünschte Winkel angeschliffen werden kann.

Aus JP-A 57 26 439 ist ein Schleifverfahren bekannt, bei welchem eine auf ein Substrat aufgelötete Halbleiterscheibe mit mehrstufigen Randabschrägungen versehen werden kann. Zum Bearbeiten werden Schleifscheiben verwendet, die mit geeignet abgeschrägten Stirnseiten versehen sind. Die Achsen der Schleifscheiben rotieren parallel zur Normalen der Halbleiterscheibe und sind sowohl in axialer als auch radialer Richtung verschiebbar. Das Werkstück wird um eine räumlich fixierte Achse gedreht.

Ein anderes, aus der US-PS 3,262,234 bekanntes Verfahren setzt für die Konturierung eine Sandstrahl-Methode ein.

Schliesslich ist in der DE-AS 15 39 101 beiläufig erwähnt worden, dass für das Abschrägen einer Kante bei einem Halbleiterbauelement ein Sandstrahl- oder ein Schleifvorgang eingesetzt werden könne, ohne jedoch nähere Angaben über ein praktisch durchführbares Verfahren zu machen.

Das erwähnte Ultraschallbohrverfahren ist in der Halbleiterfertigung relativ frühzeitig und auch weitgehend von dem Sandstrahlverfahren verdrängt worden, weil bei jenem Verfahren häufig Beschädigungen des Kristallgitters und Randausbrüche an der Halbleiterscheibe aufgetreten sind.

Das Sandstrahlverfahren seinerseits hat folgende Nachteile für die Serienfertigung:
- die Toleranzen des Sandstrahlprozesses sind schlecht reproduzierbar;
- die Abnützung der Sandstrahlanlage, insbesondere auch der Düsen, ist sehr gross. Instandhaltung und Reparaturen sind aber ausserordentlich kostenintensiv;
- die Bearbeitungszeit und damit die Kapazität einer Fertigungslinie hängen sehr stark von der Dicke der Halbleiterscheiben ab.

Trotz der aufgeführten Nachteile ist das Sandstrahlverfahren bis heute weitgehend eingesetzt worden, weil bessere und praktisch erprobte Konturierungsverfahren nicht zur Verfügung standen.

### Darstellung der Erfindung

Aufgabe der Erfindung ist es nun, ein Verfahren zum Anbringen einer abgeschrägten Randkontur anzugeben, dass einfach durchzuführen ist, reproduzierbare Ergebnisse liefert und einen vergleichsweise geringen technischen Aufwand erfordert.

Erfindungsgemäss wird die Aufgabe dadurch gelöst, dass bei einem Verfahren der genannten Art, zur Zentrierung der Anordnung aus Halbleiterscheibe und Molybdänscheibe beim Schleifen eine senkrecht zur Drehachse bewegliche Einspannvorrichtung verwendet wird; die Randkontur mit der Stirnseite der Schleifscheibe geschliffen wird, deren Schleifscheibenachse in einem der Randabschrägung entsprechenden Winkel zur Drehachse der eingespannten Halbleiterscheibe angeordnet ist; und die Molybdänscheibe während des Schleifens mit ihrem Rand an einer drehbaren Kopierscheibe abrollt, deren Kopierscheibenachse eine fixierte Lage einnimmt.

Der Kern der Erfindung besteht also darin, die abgeschrägte Randkontur rein mechanisch mit einer Schleifscheibe in die Halbleiterscheibe einzuschleifen, wobei eine ganz bestimmte Geometrie der Schleifeinrichtung eingehalten wird.

Vor dem Einspannen wird die Halbleiterscheibe auf eine Molybdänscheibe auflegiert und die Schichtanordnung aus Halbleiterscheibe und Molybdänscheibe zum Schleifen insgesamt eingespannt. Hierdurch können die mechanischen Belastungen der Halbleiterscheibe während des Schleifens erheblich verringert werden.

Gemäss einem bevorzugten Ausführungsbeispiel wird als Schleifscheibe eine Diamantschleifscheibe verwendet, bei der Diamantkörner mit einem mittleren Durchmesser von 25μm in einer Konzentration von etwa 3,3 Karat/cm³ und in einer Metallbindung vorliegen. Mit einer solchen Schleifscheibe lassen sich bei guten Standzeiten äusserst gleichmässige und eng tolerierte Randabschrägungen erzielen.

Weitere Ausführungsbeispiele ergeben sich aus den Unteransprüchen.

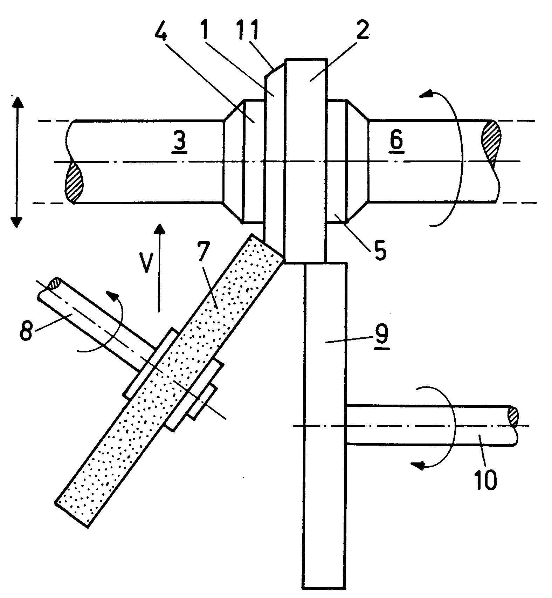

Kurze Beschreibung der Zeichnung

Die Erfindung soll nachfolgend im Zusammenhang mit der Zeichnung anhand von Ausführungsbeispielen näher erläutert werden.

Die einzige Figur der Zeichnung zeigt die geometrische Anordnung einer Schleifvorrichtung, wie sie zur Ausführung des Verfahrens gemäss einem bevorzugten Ausführungsbeispiel der Erfindung verwendet werden kann.

Wege zur Ausführung der Erfindung

In der einzigen Figur ist schematisch eine Schleifvorrichtung dargestellt, mit der eine angeschrägte Randkontur in eine Halbleiterscheibe eingeschliffen werden kann.

Die Halbleiterscheibe 1 wird dazu bevorzugt zunächst auf eine Molybdänscheibe 2 auflegiert, die zugleich den späteren Legierungskontakt des fertigen Bauelements darstellt.

Die Schichtanordnung aus Halbleiterscheibe 1 und Molybdänscheibe 2 wird dann, wie in der Figur gezeigt, zwischen zwei Spannwerkzeugen 3 und 6 mit entsprechenden Spannbacken 4 und 5 eingespannt. Die Spannwerkzeuge 3 und 6 sind drehbar gelagert, so dass die eingespannte Halbleiterscheibe 1 während des Schleifvorgangs gedreht werden kann.

In einem Winkel zur Drehachse der aus den Spannwerkzeugen 3 und 6 bestehenden Einspannvorrichtung ist auf einer Schleifscheibenachse 8 eine Schleifscheibe 7 angeordnet und so ausgerichtet, dass sie mit ihrer Stirnseite die gewünschte Randabschrägung in die Halbleiterscheibe 1 einschleifen kann. Der Winkel der Randabschrägung bestimmt sich dabei durch den Winkel zwischen der Drehachse der Einspannvorrichtung und der Schleifscheibenachse 8.

Um die Halbleiterscheibe 1 über den gesamten Umfang mit einer gleichmässigen Randkontur versehen zu können, wäre es bei einer Einspannvorrichtung mit feststehender Drehachse notwendig, die Halbleiterscheibe 1 beim Einspannen genau zu zentrieren. Dieser zeitaufwendige und fehlerbehaftete Zentriervorgang kann umgangen werden, wenn eine Einspannvorrichtung verwendet wird, die (wie in der Figur durch den Doppelpfeil angedeutet) senkrecht zur Drehachse beweglich ist.

Die eingespannte Molybdänscheibe 2 wird dann nach dem Einspannen mit ihrem Rand in Kontakt mit einer drehbaren Kopierscheibe 9 gebracht, deren Kopierscheibenachse 10 eine fixierte Lage einnimmt.

Wenn nun während des Schleifens die Molybdänscheibe 2 an der Kopierscheibe 9 abrollt, läuft sie und damit auch die Halbleiterscheibe 1, relativ zur Schleifscheibe 7 rund, selbst wenn sie in der Einspannvorrichtung nicht zentriert eingespannt ist. Die fehlende Zentrierung beim Einspannen macht sich dann darin bemerkbar, dass die Spannwerkzeuge 3, 6 eine oszillierende Bewegung in Richtung des Doppelpfeils ausführen.

Während des Schleifvorgangs wird die Schleifscheibe 7 (in der Figur durch den einfachen Pfeil angedeutet) mit einem Vorschub V in Richtung auf die Halbleiterscheibe 1 bewegt. Bei der nachfolgend näher beschriebenen Diamantschleifscheibe wird vorzugsweise ein Vorschub V von 4 mm/min gewählt, um kurze Bearbeitungszeiten bei gleichzeitig guter Oberflächenbeschaffenheit zu erhalten.

Für die Serienfertigung von Silizium-Dioden mit Sperrspannungen von 300 V bis 6000 V und Dikken der Halbleiterscheiben vom 200 m bis 1000 m hat sich eine Diamantschleifscheibe mit den folgenden Eigenschaften bewährt:
- die Schleifscheibe hat einen Durchmesser von etwa 150 mm;
- sie enthält Diamantkörner mit einem mittleren Durchmesser von 25 $\mu$m;
- die Konzentration der Diamantkörner beträgt etwa 3,3 Karat/cm$^3$ (C75); und
- die Diamantkörner lieg en in der Schleifscheibe in einer Metallbindung vor;

Mit dieser bewährten Schleifscheibe wird vorzugsweise mit einer Schnittgeschwindigkeit von etwa 22 m/s geschliffen. Als besonders günstig hat es sich dabei erwiesen, die Halbleiterscheibe 1 während des Schleifens gegenläufig zur Schleifscheibe 7 mit etwa 30 Umdrehungen/min zu drehen.

Als Kühlflüssigkeit wird bevorzugt einfaches Wasser verwendet, dem zum Schutz der Schleifeinrichtung ein Rostschutzmittel beigegeben wird.

Insgesamt steht mit der Erfindung ein Verfahren zur Verfügung, das
- exakt reprodzierbare Form und Toleranzen des positiven Winkels (Randabschrägung) garantiert,
- die Kapazität der Anlage nicht von der Dicke der Halbleiterscheibe abhängig macht, und
- eine kleine Ausfallhäufigkeit und einen geringen Unterhalt der Anlage ermöglicht.

**Patentansprüche**

1. Verfahren zum Anbringen einer abgeschrägten Randkontur (11) an einer Halbleiterscheibe (1) mit folgenden Schritten:

a) Die Halbleiterscheibe (1) wird auf eine Molybdänscheibe (2) auflegiert;

b) die Schichtanordnung aus Halbleiterscheibe (1) und Molybdänscheibe (2) wird in der Scheibenebene drehbar eingespannt; und

c) die Randkontur (11) wird mit einer rotierenden Schleifscheibe (7) in die Halbleiterscheibe (1) geschliffen;

dadurch gekennzeichnet, dass

d) zur Zentrierung der Anordnung aus Halbleiterscheibe (1) und Molybdänscheibe (2) beim Schleifen eine senkrecht zur Drehachse bewegliche Einspannvorrichtung verwendet wird;

e) die Randkontur (11) mit der Stirnseite der Schleifscheibe (7) geschliffen wird, deren Schleifscheibenachse (8) in einem der Randabschrägung entsprechenden Winkel zur Drehachse der eingespannten Halbleiterscheibe (1) angeordnet ist; und

f) die Molybdänscheibe (2) während des Schleifens mit ihrem Rand an einer drehbaren Kopierscheibe (9) abrollt, deren Kopierscheibenachse (10) eine fixierte Lage einnimmt.

2. Verfahren nach Anspruch 1, dadurch gekennzeichnet, dass die Schleifscheibe (7) während des Schleifens mit einem Vorschub (V) parallel zur Scheibenebene und in Richtung der Halbleiterscheibe (1) betrieben wird, und der Vorschub (V) vorzugsweise etwa 4 mm/min beträgt.

3. Verfahren nach Anspruch 1, dadurch gekennzeichnet dass als Schleifscheibe (7) eine Diamantschleifscheibe verwendet wird.

4. Verfahren nach Anspruch 5, dadurch gekennzeichnet, dass die Schleifscheibe (7) Diamantkörner mit einem mittleren Durchmesser von 25 $\mu$m enthält, dass die Diamantkörner eine Konzentration von etwa 3,3 Karat/cm$^3$ haben, und dass die Diamantkörner in der Schleifscheibe (7) in einer Metallbindung vorliegen.

5. Verfahren nach Anspruch 5, dadurch gekennzeichnet, dass die Schleifscheibe (7) einen Durchmesser von etwa 150 mm aufweist.

6. Verfahren nach Anspruch 6, dadurch gekennzeichnet, dass die Schnittgeschwindigkeit beim Schleifen etwa 22 m/s beträgt.

7. Verfahren nach Anspruch 1, dadurch gekennzeichnet, dass die Halbleiterscheibe (1) während des Schleifens gegenläufig zur Schleifscheibe (7) gedreht wird und die Rotation mit etwa 30 U/min erfolgt.

8. Verfahren nach Anspruch 5, dadurch gekennzeichnet, dass als Kühlflüssigkeit beim Schleifen Wasser verwendet wird.

**Claims**

1. Method of producing a bevelled peripheral profile (11) on a semiconductor disc (1) having the following steps:

a) the semiconductor disc (1) is bonded onto a molybdenum disc (2);

b) the laminate consisting of semiconductor disc (1) and molybdenum disc (2) is rotatably clamped in the disc plane; and

c) the peripheral profile (11) is ground on the semiconductor disc (1) by a rotating grinding disc (7);

characterised in that

d) in order to centre the assembly of semiconductor disc (1) and molybdenum disc (2) during grinding, a clamping device is used which is movable perpendicularly to the axis of rotation;

e) the peripheral profile (11) is ground with the working face of the grinding disc (7), the grinding disc axis (8) of which is arranged at an angle to the axis of rotation of the clamped semiconductor disc (1) corresponding to the peripheral bevelling; and

f) during the grinding, the molybdenum disc (2) rolls with its periphery against a rotatable guide disc (9), the guide disc axis (10) of which occupies a fixed position.

2. Method according to Claim 1, characterised in that, during the grinding, the grinding disc (7) is driven with a feed (V) parallel to the disc plane and in the direction of the semiconductor disc (1) and the feed (V) preferably amounts to about 4 mm/min.

3. Method according to Claim 1, characterised in that a diamond grinding disc is used as the grinding disc (7).

4. Method according to Claim 5 [sic], characterised in that the grinding disc (7) contains diamond grains with a mean diameter of 25 $\mu$m, in that the diamond grains have a concentration of about 3.3 carat/cm$^3$, and in that the diamond grains are present in the grinding disc (7) in a metallic bond.

5. Method according to Claim 5 [sic], characterised in that the grinding disc (7) has a diameter of about 150 mm.

6. Method according to Claim 6 [sic], characterised in that the cutting speed during grinding amounts to about 22 m/s.

7. Method according to Claim 1, characterised in that, during the grinding, the semiconductor disc (1) is rotated in the opposite direction to the grinding disc (7), and the rotation occurs at about 30 revs/min.

8. Method according to Claim 5 [sic], characterised in that water is used as cooling fluid during grinding.

**Revendications**

1. Procédé pour réaliser un profil périphérique chanfreiné (11) sur un disque semi-conducteur (1), comprenant les étapes suivantes:
   a) le disque semi-conducteur (1) est fixé par alliage sur un disque de molybdène (2);
   b) l'ensemble stratifié composé du disque semi-conducteur (1) et du disque de molybdène (2) est serré en étant rotatif dans le plan du disque; et
   c) le profil périphérique (11) est meulé dans le disque semi-conducteur (1) au moyen d'une meule rotative (7);
   caractérisé en ce que
   d) pour le centrage de l'ensemble composé du disque semi-conducteur (1) et du disque de molybdène (2) lors du meulage, on utilise un dispositif de serrage mobile perpendiculairement à l'axe de rotation;
   e) le profil périphérique (11) est meulé avec la face frontale de la meule (7), avec l'axe (8) de la meule disposé avec un angle correspondant au chanfrein du bord par rapport au disque semi-conducteur serré; et
   f) le disque de molybdène (2) roule pendant le meulage par son bord sur un disque de copie rotatif (9), avec l'axe (10) du disque de copie occupant une position fixe.

2. Procédé suivant la revendication 1, caractérisé en ce que la meule (7) opère, pendant le meulage, avec une avance (V) parallèlement au plan de meulage et en direction du disque semi-conducteur (1), et en ce que l'avance (V) est de préférence d'environ 4 mm/min.

3. Procédé suivant la revendication 1, caractérisé en ce que, comme meule (7), on utilise une meule en diamant.

4. Procédé suivant la revendication 3, caractérisé en ce que la meule (7) contient des grains de diamant ayant un diamètre moyen de 25 $\mu$m, en ce que les grains de diamant ont une concentration d'environ 3,3 carat/cm$_3$, et en ce que les grains de diamant ont une liaison métallique dans la meule (7).

5. Procédé suivant la revendication 3, caractérisé en ce que la meule (7) présente un diamètre d'environ 150 mm.

6. Procédé suivant la revendication 4, caractérisé en ce que la vitesse de coupe au meulage est d'environ 22 m/s.

7. Procédé suivant la revendication 1, caractérisé en ce que le disque semi-conducteur (1) est mis en rotation, pendant le meulage, dans le sens contraire de la meule (7) et en ce qu'il tourne à environ 30 tours/min.

8. Procédé suivant la revendication 3, caractérisé en ce que l'on utilise l'eau comme liquide de refroidissement pendant le meulage.